(19) Europäisches Patentamt
European Patent Office
Office européen des brevets

(11) **EP 3 510 639 B1**

(12) **FASCICULE DE BREVET EUROPEEN**

(45) Date de publication et mention de la délivrance du brevet:
**05.08.2020 Bulletin 2020/32**

(21) Numéro de dépôt: **17771814.5**

(22) Date de dépôt: **07.09.2017**

(51) Int Cl.:
*H01L 31/18* (2006.01)   *C30B 29/06* (2006.01)

(86) Numéro de dépôt international:
**PCT/FR2017/052374**

(87) Numéro de publication internationale:
**WO 2018/046854 (15.03.2018 Gazette 2018/11)**

(54) **PROCÉDÉ DE TRI DE PLAQUETTES EN SILICIUM EN FONCTION DE LA VARIATION DU DOPAGE NET**

VERFAHREN ZUM SORTIEREN VON SILICIUMSCHEIBEN NACH DER NETTODOTIERVARIATION

METHOD FOR SORTING SILICON WAFERS ACCORDING TO THE NET DOPING VARIATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.09.2016 FR 1658365**

(43) Date de publication de la demande:
**17.07.2019 Bulletin 2019/29**

(73) Titulaire: **Commissariat à l'Énergie Atomique et aux Énergies Alternatives 75015 Paris (FR)**

(72) Inventeurs:
- **LETTY, Elénore**
  **38300 Bourgoin Jallieu (FR)**
- **FAVRE, Wilfried**
  **73000 Chambery (FR)**
- **VEIRMAN, Jordi**
  **73290 La Motte-Servolex (FR)**

(74) Mandataire: **Cabinet Camus Lebkiri 25 rue de Maubeuge 75009 Paris (FR)**

(56) Documents cités:
**US-A- 3 372 003    US-A1- 2007 193 501**

**Description**

**DOMAINE TECHNIQUE**

La présente invention concerne un procédé de tri de plaquettes en silicium, mis en œuvre après leur découpage dans un lingot et avant qu'elles ne soient utilisées pour la fabrication de dispositifs semi-conducteurs, tels que des cellules photovoltaïques.

**ÉTAT DE LA TECHNIQUE**

Environ 10 % à 20 % des plaquettes en silicium monocristallin obtenues par le procédé de tirage Czochralski sont incompatibles avec la fabrication de cellules photovoltaïques à haut rendement. En effet, ces plaquettes contiennent des défauts qui limitent la durée de vie des porteurs de charge photogénérés et conduisent à des diminutions de rendement pouvant atteindre 4 % (absolu).

Parmi les défauts qui limitent la durée de vie, on peut citer les donneurs thermiques (DT). Les donneurs thermiques sont des agglomérats créés à partir de l'oxygène interstitiel contenu dans le silicium (i.e. les atomes d'oxygène occupent des positions interstitielles dans le réseau cristallin). Ils se forment lors du tirage du lingot, lorsque la température de silicium est comprise entre 350 °C et 500 °C.

Les plaquettes dont la concentration en donneurs thermiques est la plus élevée et dont le rendement risque par conséquent d'être limité sont généralement situées dans la partie haute du lingot, appelée également tête du lingot. Cela s'explique d'une part par le fait que la partie haute du lingot (i.e. la partie du lingot cristallisée en premier) contient une plus grande quantité d'oxygène, et d'autre part, par le fait qu'elle subit un refroidissement plus lent que la partie basse du lingot (cristallisée en dernier). En effet, elle reste en contact thermique avec le bain de silicium fondu pendant toute la durée du tirage. La durée pendant laquelle la température du silicium se situe dans la plage de formation des donneurs thermiques (350 °C-500 °C) est donc plus importante pour la partie haute du lingot que pour sa partie basse.

Les donneurs thermiques sont détruits lors d'un traitement thermique à une température supérieure ou égale à 600 °C. Les cellules photovoltaïques à homojonction, dont le procédé de fabrication fait appel à de tels traitements thermiques, ne contiennent donc (quasiment) plus de donneurs thermiques et leur rendement n'est pas diminué. Par contre, les procédés de fabrication de cellules photovoltaïques à basse température (<250 °C), tel que le procédé de fabrication de cellules à hétérojonction en silicium (amorphe/cristallin), ne permettent pas de supprimer les donneurs thermiques. Ces donneurs thermiques affecteront les performances des cellules à hétérojonction en réduisant la durée de vie volumique des porteurs.

Il n'existe à l'heure actuelle aucune solution pour déterminer a priori, c'est-à-dire en entrée d'une ligne de production de cellules lorsque les plaquettes sont dans un état brut de découpe (« as-cut state » en anglais), quel sera l'impact des donneurs thermiques présents dans les plaquettes sur les performances futures des cellules photovoltaïques à hétérojonction. Une telle information permettrait d'écarter les plaquettes de mauvaise qualité avant qu'elles n'entament le procédé de fabrication de cellules, réalisant ainsi d'importantes économies.

Le document [« Quality Control of Czochralski Grown Silicon Wafers in Solar Cell Production Using Photoluminescence Imaging », J. Haunschild et al., 26th European PV Solar Energy Conférence and Exhibition, 5-9 September 2011, Hamburg] propose une méthode de tri de plaquettes destinées à la fabrication de cellules photovoltaïques à homojonction, sur la base d'images de photoluminescence des plaquettes. Les images de photoluminescence (utilisées pour effectuer le tri) sont prises après que les plaquettes aient subi une étape de diffusion d'émetteur à haute température. Les plaquettes ne sont donc plus dans l'état brut de découpe. Lorsque l'image de photoluminescence d'une plaquette montre un ou plusieurs cercles noirs (i.e. un signal de photoluminescence faible), cela signifie que le rendement de la cellule photovoltaïque finie sera faible à cause de la présence de précipités d'oxygène. Cette plaquette peut donc être écartée.

Ces précipités d'oxygène sont des défauts liés à l'oxygène, différents des donneurs thermiques, et ne peuvent être différenciés des donneurs thermiques sur une image de photoluminescence qu'après avoir détruit les donneurs thermiques présents initialement dans les plaquettes (d'où la nécessité d'avoir recours à l'étape de diffusion à haute température). En effet, les images de photoluminescence de plaquettes contenant des fortes concentrations en donneurs thermiques montrent systématiquement des cercles noirs, rendant impossible la différenciation entre les plaquettes de haut rendement et les plaquettes de faible rendement (après fabrication des cellules à homojonction).

Cette méthode de tri n'est donc pas applicable à des plaquettes de silicium dans l'état brut de découpe, en raison de la présence des donneurs thermiques. De façon plus générale, le document susmentionné ne s'intéresse aucunement à l'influence des donneurs thermiques sur les performances d'une cellule photovoltaïque à hétérojonction. Il concerne la fabrication de cellules photovoltaïques à homojonction, au cours de laquelle les donneurs thermiques sont détruits (ils sont qualifiés d'inoffensifs dans le document).

En outre, cette méthode de tri des plaquettes ne permet pas d'optimiser au maximum la fabrication de cellules à homojonction, car elle requiert d'accomplir systématiquement la première étape du procédé de fabrication : la diffusion de l'émetteur (par exemple 10 s à 800 °C). Cette étape représente une dépense inutile lorsque les plaquettes sont finalement écartées.

US2007/0193501 décrit la réalisation de test de résistivité durant la fabrication de lingots en silicium.

## RÉSUMÉ DE L'INVENTION

Il existe donc un besoin de prévoir un procédé de tri de plaquettes en silicium monocristallin de type Czochralski, permettant d'écarter à moindre coût des plaquettes de mauvaise qualité. Une plaquette est dite de mauvaise qualité lorsque les performances du dispositif (ou des dispositifs) semi-conducteur(s) formé(s) sur cette plaquette sont faibles.

Selon l'invention, on tend à satisfaire ce besoin en prévoyant un procédé de tri de plaquettes, mis en œuvre lorsque les plaquettes sont dans un état brut de découpe ou dans un état de mise en forme de leur surface, ce procédé comprenant les étapes suivantes :

a) mesurer une première valeur d'un paramètre représentatif de la concentration en porteurs de charge libres dans une première zone située au centre de chaque plaquette et une deuxième valeur dudit paramètre dans une deuxième zone située au voisinage immédiat d'un bord de chaque plaquette ;
b) calculer une variation relative dudit paramètre entre le bord et le centre de chaque plaquette, à partir des première et deuxième valeurs dudit paramètre ;
c) comparer la variation relative dudit paramètre dans chaque plaquette à une valeur seuil ; et
d) écarter la plaquette lorsque la variation relative dudit paramètre est supérieure à la valeur seuil.

L'état « brut de découpe » désigne l'état dans lequel le fabricant de lingots fournit les plaquettes de silicium aux fabricants de dispositifs semi-conducteurs. À ce stade, les plaquettes n'ont subi encore aucune étape d'un quelconque procédé de fabrication de dispositifs semi-conducteurs. Plus particulièrement, elles n'ont subi aucune étape susceptible de modifier la réflectivité de la plaquette (ex. étape de texturation), de modifier la durée de vie volumique ou surfacique des porteurs de charge (ex. étape de passivation), de modifier la concentration en porteurs de charge (ex. dopage) ou la concentration en donneurs thermiques (ex. recuit). Éventuellement, les plaquettes peuvent avoir fait l'objet d'un nettoyage, afin d'enlever des résidus de découpe (ex. poussière), mais sans modification de leur surface.

Les plaquettes se trouvent dans l'état dit « de mise en forme de leur surface » après que les plaquettes brutes de découpe aient subi une étape de mise en forme de leur surface, telle qu'une étape de texturation ou une étape de polissage mécanique et/ou chimique.

Le procédé selon l'invention effectue un tri de plaquettes sur la base d'un paramètre représentatif de leur concentration en porteurs de charge libres majoritaires, appelée communément « dopage net ». Lorsque la variation relative de ce paramètre, entre le bord et le centre de la plaquette, est supérieure à la valeur seuil, cela signifie que la concentration en porteurs de charge libres majoritaires varie de façon excessive, en raison d'une concentration élevée en donneurs thermiques au centre de la plaquette. La plaquette est alors écartée, car le risque qu'elle soit de mauvaise qualité est particulièrement élevé. Les donneurs thermiques sont en effet parmi les défauts qui limiteront le plus les performances finales de la plaquette de silicium, en particulier la durée de vie volumique des porteurs de charge libres.

Le paramètre représentatif de la concentration en porteurs de charge libres majoritaires peut être le signal d'un équipement de caractérisation, qui varie en fonction de la concentration en porteurs de charge libres majoritaires, par exemple la résistivité électrique ou la réflectivité aux micro-ondes. Par définition, l'expression « paramètre représentatif de la concentration en porteurs de charge libres majoritaires » peut faire référence à la concentration en porteurs de charge libres majoritaires en elle-même.

En dehors des étapes de calcul et de comparaison à la valeur seuil, le procédé de tri selon l'invention ne requiert que deux mesures représentatives de la concentration en porteurs de charge libres majoritaires. Il est donc particulièrement simple et économique à mettre en œuvre.

En particulier, il ne fait appel à aucune étape préliminaire, comme la diffusion de l'émetteur dans le procédé de tri de l'art antérieur. Autrement dit, les plaquettes restent dans l'état brut de découpe (ou de mise en forme) tout au long du procédé. L'absence d'étape préliminaire constitue une économie importante par rapport au procédé de tri de l'art antérieur.

Dans un mode de mise en œuvre préférentiel du procédé de tri, le paramètre représentatif de la concentration en porteurs de charge libres majoritaires est une intensité de photoluminescence. La photoluminescence est une technique précise et rapide qui, lorsqu'elle est utilisée en imagerie, permet d'obtenir en une seule fois une multitude de valeurs représentatives de la concentration en porteurs de charge libres.

En outre, elle permet d'effectuer la mesure de la deuxième valeur au plus près du bord de la plaquette, ce qui améliorer la précision du procédé de tri. Lorsque la technique de photoluminescence est utilisée, l'épaisseur des plaquettes est avantageusement inférieure à 580 µm.

Le procédé selon l'invention peut également présenter une ou plusieurs des caractéristiques ci-dessous, considérées individuellement ou selon toutes les combinaisons techniquement possibles :

- la première zone de chaque plaquette est constituée d'un carré de 5 mm de côté dont le centre est confondu avec le centre de la plaquette ;

- la deuxième zone de chaque plaquette est constituée d'une bande de largeur égale à 5 mm et située à la périphérie de la plaquette ;

- le paramètre représentatif de la concentration en porteurs de charge libres majoritaires est un signal proportionnel ou inversement proportionnel à la concentration en porteurs de charge libres majoritaires ;

- la première valeur dudit paramètre est une valeur moyenne de plusieurs valeurs dudit paramètre mesurées dans la première zone ;

- les étapes a) et b) sont en outre mises en œuvre pour des zones additionnelles de chaque plaquette, d'où il résulte une pluralité de valeurs de variation relative dudit paramètre pour chaque plaquette, le procédé comprenant en outre une étape de détermination, parmi la pluralité de valeurs de variation relative, d'une valeur maximale de variation relative, ladite valeur maximale étant comparée à la valeur seuil à l'étape c) ; et

- les plaquettes sont dopées de type n.

Un autre aspect de l'invention concerne un procédé de tri de plaquettes spécialement adapté aux plaquettes issues de lingots en silicium monocristallin de type Czochralski contenant des dopants de type p, dans lesquelles il existe un risque d'inversion du dopage à cause de la formation des donneurs thermiques.
Ce procédé est également mis en œuvre lorsque les plaquettes sont dans un état brut de découpe ou dans un état de mise en forme de leur surface. Il comprend les étapes suivantes :

- effectuer des mesures d'un paramètre représentatif de la concentration en porteurs de charge libres majoritaires sur chaque plaquette, les mesures étant réparties entre un bord et le centre de la plaquette ;
- déterminer si ledit paramètre diminue de façon continue entre le bord et le centre de chaque plaquette ; et

lorsque ledit paramètre diminue de façon continue, les étapes suivantes :

a) extraire des mesures une première valeur dudit paramètre dans une première zone située au centre de la plaquette et une deuxième valeur dudit paramètre dans une deuxième zone située au voisinage immédiat d'un bord de la plaquette ;
b) calculer une première variation relative dudit paramètre entre le bord et le centre dans la plaquette, à partir des première et deuxième valeurs dudit paramètre ;
c) comparer la première variation relative dudit paramètre à une première valeur seuil ; et
d) écarter la plaquette lorsque la première variation relative dudit paramètre est supérieure à la première valeur seuil ; et

lorsque ledit paramètre ne diminue pas de façon continue, les étapes suivantes :

- déterminer une deuxième variation relative dudit paramètre entre le minimum dudit paramètre et une valeur dudit paramètre au centre de la plaquette ;
- comparer la deuxième variation relative dudit paramètre à une deuxième valeur seuil ;
- écarter la plaquette lorsque la deuxième variation relative dudit paramètre est supérieure à la deuxième valeur seuil ;
- mettre en œuvre les étapes a) à d) lorsque la deuxième variation relative dudit paramètre est inférieure à la deuxième valeur seuil.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente la résistivité électrique au sein de plusieurs plaquettes de silicium, prélevées à différentes hauteurs d'un lingot de type Czochralski ;
- la figure 2 représente schématiquement des étapes S1 à S4 d'un premier procédé de tri selon l'invention ;
- la figure 3 représente schématiquement des étapes d'un deuxième procédé de tri selon l'invention, spécialement adapté à des plaquettes de silicium contenant des dopants de type p ; et
- les figures 4A et 4B représentent des courbes de l'intensité de photoluminescence pour deux plaquettes de silicium contenant des dopants de type p.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

Un lingot en silicium monocristallin obtenu par le procédé Czochralski (CZ) contient une importante quantité de donneurs thermiques, car le silicium présente une concentration élevée en oxygène interstitiel et subit un refroidissement lent. Ces donneurs thermiques se retrouvent ensuite dans les plaquettes de silicium issues de la découpe du lingot.

Les donneurs thermiques produisent deux effets sur les propriétés du silicium. Premièrement, certains agissent comme centres de recombinaison des paires électron-trou, ce qui limite la durée de vie volumique des porteurs de charge. Deuxièmement, ils influent sur la concentration en porteurs de charge libres majoritaires, appelée communément dopage net, car chaque donneur thermique génère deux électrons libres. La concentration en porteurs de charge libres majoritaires, notée ci-après no dans le cas d'un silicium dopé de type n (électrons majoritaires) et po dans le cas d'un silicium dopé de type p (trous majoritaires), s'écrit de la façon suivante :

$$n_0 = N_d + 2\,[DT] \qquad (1a)$$

$$p_0 = N_a - 2\,[DT] \qquad (1b)$$

où $N_d$ est la concentration en dopants donneurs (phosphore, arsenic, antimoine...) introduits volontairement dans le silicium, $N_a$ est la concentration en dopants accepteurs (bore, gallium, aluminium...) introduits volontairement dans le silicium, et [DT] est la concentration en donneurs thermiques formés au cours du tirage du lingot.

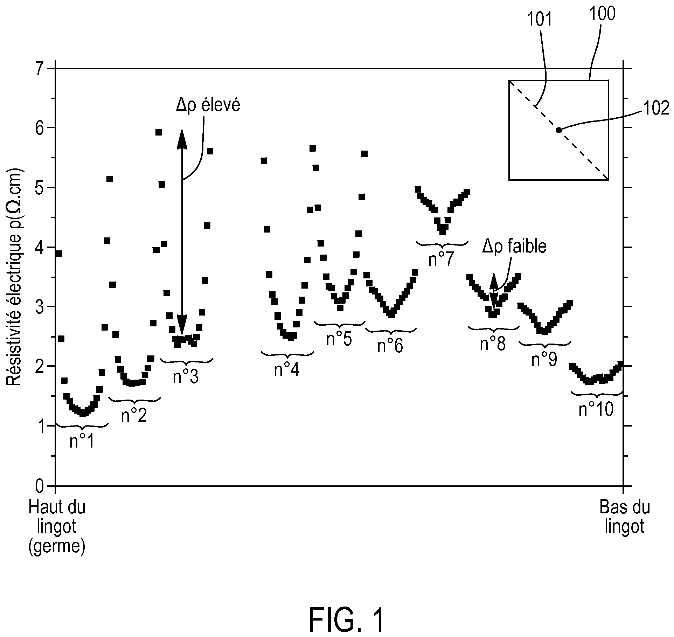

La figure 1 représente la résistivité électrique p de dix plaquettes 100 au format carré, mesurée en différents points répartis sur une diagonale 101 de chaque plaquette. Les plaquettes 100, numérotées de 1 à 10, ont été prélevées à différentes hauteurs dans un lingot de silicium CZ dopé au phosphore (type n). La plaquette n°1 provient de la partie haute du lingot (c'est-à-dire la partie cristallisée en premier, du côté du germe), tandis que la plaquette n°10 provient de la partie basse du lingot (c'est-à-dire la partie cristallisée en dernier, à l'opposé du germe).

Pour chaque plaquette 100, on observe une variation de la résistivité électrique, notée Δρ sur la figure 1, entre une zone proche du centre 102 de la plaquette et les deux angles de la plaquette situés aux extrémités de la diagonale 101. Cette variation de la résistivité Δρ est dite radiale, car elle s'étend sur un rayon du lingot dans le plan de coupe de la plaquette. La résistivité p étant liée à la concentration en porteurs de charge majoritaires libres $n_0/p_0$, elle-même influencée par la concentration en donneurs thermiques [DT] (cf. relation (1a) ou (1b) ci-dessus), la variation radiale de la résistivité Δρ s'explique par une concentration en donneurs thermiques [DT] au centre supérieure à celle aux angles de la plaquette.

Il a en effet été démontré à plusieurs reprises dans la littérature que la répartition des donneurs thermiques au sein d'une plaquette en silicium CZ n'est pas uniforme : la concentration en donneurs thermiques [DT] est généralement maximale dans une zone située au centre de la plaquette et diminue progressivement en s'éloignant du centre de la plaquette. Comme indiqué dans l'article [« A New Method for the Détermination of the Dopant-Related Base Resistivity Despite the Presence of Thermal Donors », J. Broisch et al., IEEE Journal of Photovoltaics, Vol.5, No.1, 2015], ce phénomène est due d'une part à une concentration en oxygène interstitiel plus élevée au centre qu'à la périphérie du lingot, et d'autre part, à un refroidissement progressif du silicium, de l'extérieur vers l'intérieur du lingot.

On constate également sur la figure 1 que la variation radiale de la résistivité Δρ est bien plus importante pour les plaquettes situées dans la partie haute du lingot que pour les plaquettes situées dans la partie basse du lingot. Une variation de résistivité Δρ élevée est le signe d'une concentration en donneurs thermiques particulièrement forte au centre de la plaquette, car la concentration en donneurs thermiques à la périphérie d'une plaquette reste comparable quelle que soit la position dans le lingot. Il existe par conséquent, outre la variation radiale de la concentration en donneurs thermiques observée au sein de chaque plaquette, une variation axiale de la concentration en donneurs thermiques dans le lingot (i.e. le long de l'axe de symétrie du lingot).

Les procédés de tri décrits ci-après mettent en application ce constat et permettent d'écarter une plaquette lorsqu'un paramètre représentatif de sa concentration en porteurs de charge libres majoritaires no/po, tel que la résistivité électrique (cf. Fig.1), varie (radialement) au-delà d'une certaine proportion. Ces procédés sont mis en œuvre lorsque les plaquettes sont, de préférence, à l'état brut de découpe.

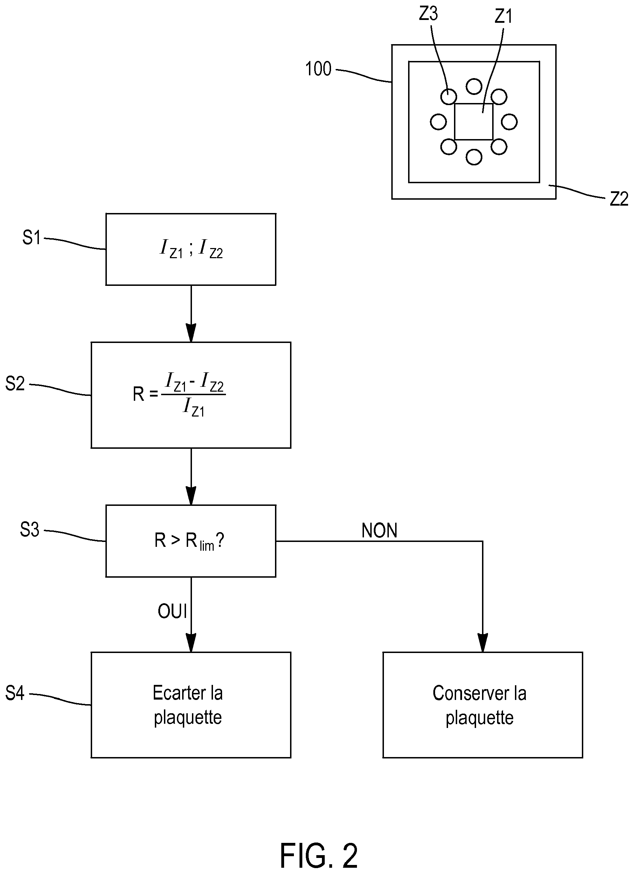

La figure 2 représente schématiquement des étapes S1 à S4 d'un premier procédé de tri de plaquettes en silicium. Ces plaquettes sont par exemple destinées à la fabrication de cellules photovoltaïques. La forme des plaquettes peut être quelconque, par exemple circulaire, carrée ou pseudo-carrée.

L'étape S1 consiste à mesurer un paramètre I représentatif de la concentration en porteurs de charge libres majoritaires no/po dans deux zones de chaque plaquette à trier. Une première valeur du paramètre I, notée $I_{Z1}$, est mesurée dans une première zone Z1 située au centre des plaquettes, et une deuxième valeur du même paramètre I, notée $I_{Z2}$, est mesurée dans une deuxième zone Z2 située près d'un bord des plaquettes.

La première zone de mesure Z1 est de préférence un carré de 5 cm de côté dont le centre est confondu avec le centre de la plaquette. La deuxième zone Z2 est située au voisinage immédiat d'un bord de la plaquette. Par « voisinage immédiat d'un bord de la plaquette », on entend à une distance inférieure à 5 mm, préférentiellement inférieure à 1 mm, du bord de la plaquette. Autrement dit, la deuxième zone Z2 est constituée d'une bande de largeur égale à 5 mm, préférentiellement égale à 1 mm, située à la périphérie de la plaquette.

De préférence, la deuxième valeur $I_{Z2}$ du paramètre I est mesurée dans l'une des régions les plus éloignées du centre de la plaquette. Lorsque les plaquettes sont au format carré, la deuxième valeur $I_{Z2}$ du paramètre I est avantageusement mesurée dans l'un des angles de chaque plaquette, à moins de 5 mm des deux bords adjacents qui forment cet angle, et de préférence à moins de 1 mm de ces mêmes bords. Lorsque les plaquettes ont une forme pseudo-carrée, la deuxième valeur $I_{Z2}$ du paramètre I est avantageusement mesurée à proximité immédiate de l'un des angles tronqués de la plaquette, c'est-à-dire à moins de 5 mm de l'arrête formée par la troncature de l'angle, et de préférence à moins de 1 mm de cette arrête.

Le paramètre I représentatif de la concentration en porteurs de charge libres majoritaires no/po est avantageusement un signal fourni par un équipement de caractérisation, qui varie en fonction de la concentration en porteurs de charge libres majoritaires. Autrement dit, ce signal est l'image de la concentration en porteurs de charge libres majoritaires no/po. Le paramètre I peut notamment être la résistivité électrique (par exemple fournie par la méthode des quatre pointes) ou la réflectivité aux micro-ondes (par exemple mesurée par la technique de conductivité micro-onde résolue en temps, ou « Time Resolved Microwave Conductivity » en anglais).

Puis, une variation relative R du paramètre I dans chaque plaquette est calculée lors d'une étape S2, à partir des première et deuxième valeurs $I_{Z1}$-$I_{Z2}$ mesurées à l'étape S1. La variation relative R du paramètre I s'écrit de la façon suivante :

$$R = \frac{|I_{Z1} - I_{Z2}|}{I_{Z1}}$$

La variation relative R peut être qualifiée de variation « radiale », puisqu'elle représente l'évolution de la concentration en porteurs de charge libres majoritaires sur un rayon du lingot dans lequel ont été découpées les plaquettes de silicium.

Le fait de calculer la variation relative R directement avec le signal de l'équipement de caractérisation utilisé à l'étape S1, plutôt qu'avec la concentration en porteurs de charge libres majoritaires $n_0/p_0$, simplifie le procédé de tri, car on évite ainsi les étapes de calcul intermédiaires permettant de remonter à la concentration en porteurs de charge libres majoritaires $n_0/p_0$.

En outre, lorsque ce signal est proportionnel ou inversement proportionnel à la concentration en porteurs de charge libres majoritaires $n_0/p_0$, il n'est pas nécessaire de connaître le facteur de proportionnalité entre le signal et la concentration en porteurs de charge libres majoritaires $n_0/p_0$ pour calculer la variation relative R. Le procédé de tri ne requiert donc pas d'étape préalable de calibration de l'équipement, cette calibration ayant généralement pour but de déterminer la relation qui lie le signal de mesure à la concentration en porteurs de charge libres majoritaires $n_0/p_0$.

Le procédé de tri de la figure 2 comporte ensuite une étape S3 qui consiste à comparer la variation radiale relative R de chaque plaquette à une valeur seuil, notée ci-après $R_{lim}$. Lorsque la variation radiale relative R d'une plaquette est inférieure au seuil $R_{lim}$ (sortie « NON » en S3), cela signifie que la qualité de la plaquette est satisfaisante. En effet, une faible valeur de la variation radiale relative R indique que la concentration en donneurs thermiques maximale au centre de la plaquette est a priori faible. La plaquette peut donc être conservée, car ses performances ne seront pas trop diminuées par les donneurs thermiques. À l'inverse, lorsque la variation radiale relative R est supérieure au seuil $R_{lim}$ (sortie « OUI » en S3), la plaquette est considérée comme défectueuse en raison d'une forte concentration en donneurs thermiques au centre de la plaquette. Elle est alors écartée lors d'une étape finale S4 du procédé de tri.

En général, le centre de la plaquette est la zone où la concentration en donneurs thermiques est la plus élevée, et la périphérie de la plaquette est celle où la concentration en donneurs thermiques est la plus faible. Ainsi, la variation relative R du paramètre I calculée à l'étape S2 en faisant la différence des première et deuxième valeurs $I_{Z1}$-$I_{Z2}$ est en principe maximale. Ce choix des zones de mesure garantit une efficacité maximale au procédé de tri, tout en réduisant au minimum le nombre de mesures.

Dans un souci de précision, au cas où la valeur maximale de la concentration en donneurs thermiques ne se situerait pas dans la zone centrale Z1 de la plaquette, les étapes S1 et S2 du procédé de tri peuvent être mises en œuvre dans des zones additionnelles Z3 de chaque plaquette, par exemple disposées autour de la zone centrale Z1 (cf. Fig.2). Plusieurs valeurs de la variation relative R sont ainsi calculées. Le procédé de tri comporte alors avantageusement une étape consistant à déterminer, parmi ces différentes valeurs de la variation relative R, celle qui est la plus élevée, autrement dit la plus contraignante pour effectuer le tri. La comparaison de l'étape S3 est ensuite effectuée entre la valeur seuil $R_{lim}$ et cette valeur maximale de la variation relative R.

Pour les mêmes raisons, il peut être avantageux de mesurer à l'étape S1 plusieurs valeurs du paramètre I dans la zone centrale Z1 de la plaquette, puis de moyenner ces différentes valeurs. La variation relative R est alors calculée à l'étape S2 en prenant comme première valeur $I_{Z1}$ la moyenne des valeurs issues de la zone centrale Z1.

La valeur seuil $R_{lim}$ est de préférence définie en fonction des performances de cellules photovoltaïques attendues par les fabricants, compte tenu du procédé utilisé pour fabriquer ces cellules. Elle peut être déterminée de manière empirique par chaque fabricant de cellules photovoltaïques grâce à un échantillon de plaquettes, en comparant les variations radiales relatives R des plaquettes de l'échantillon aux rendements des cellules photovoltaïques obtenues à partir de ces plaquettes.

La valeur seuil $R_{lim}$ peut également être fixée en tenant compte de la concentration en dopants accepteurs ou donneurs des plaquettes. En effet, en choisissant une valeur seuil $R_{lim}$ trop contraignante, c'est-à-dire très faible, on risque d'écarter à tort des plaquettes dont la variation du paramètre I est due à variation de la concentration en dopants. On estime que la concentration en dopants peut varier entre le bord et le centre de la plaquette d'au maximum 30 %. La valeur seuil $R_{lim}$ devrait donc être au minimum de 0,3.

À titre d'exemple, on souhaite écarter des plaquettes qui conduisent à une diminution d'au moins 0,1 % du rendement, par rapport à un rendement cible de 20 %. Pour ce faire, la valeur seuil $R_{lim}$ est fixée à une valeur comprise entre 0,60 et 0,80. Toutes les plaquettes présentant une variation radiale relative R supérieure à cette valeur seront alors mises de côté. Cet exemple de valeur seuil $R_{lim}$ a été déterminé en mesurant la variation relative du paramètre I pour dix plaquettes test, puis en mesurant le rendement des cellules photovoltaïques obtenues à partir de ces mêmes plaquettes. La première valeur $I_{Z1}$ du paramètre I (permettant de calculer la variation relative du paramètre I dans chaque plaquette test) a été obtenue en faisant la moyenne des valeurs mesurées dans une zone carrée Z1 de 5 mm par 5 mm située au centre de la plaquette. La deuxième valeur $I_{Z2}$ du paramètre I a été obtenue en faisant la moyenne de plusieurs valeurs du paramètre I réparties dans quatre zones Z2 situées à 1 mm des quatre angles de la plaquette. Chaque zone Z2 est de forme carrée (2 mm x 2 mm) et comprend plusieurs points de mesure.

Dans un mode de mise en œuvre préférentiel du procédé de tri, le paramètre représentatif de la concentration en porteurs de charge libres mesuré à l'étape S1 est l'intensité de photoluminescence $I_{PL}$. La photoluminescence est une technique répandue pour caractériser un matériau semi-conducteur. Elle repose sur l'excitation du matériau semi-conducteur par une source lumineuse afin de générer des porteurs de charge libres et sur la détection optique des recombinaisons radiatives de ces porteurs. L'intensité de photoluminescence obtenue dans une zone de mesure de la plaquette s'exprime (à faible niveau d'injection) par la relation suivante :

$$I_{PL} \propto n_0\, G\, \tau_{eff} \qquad \text{dans le silicium type n ;}$$

$$I_{PL} \propto p_0\, G\, \tau_{eff} \qquad \text{dans le silicium type p ;}$$

où $\tau_{eff}$ est la durée de vie effective des porteurs de charge photogénérés et $G$ le taux de génération de porteurs de charge.

Dans une plaquette brute de découpe dont l'épaisseur est faible, typiquement inférieure à 580 $\mu$m, la durée de vie effective des porteurs de charge $\tau_{eff}$ est essentiellement limitée par les recombinaisons en surface. En effet, la passivation des défauts présents en surface de la plaquette n'ayant pas encore eu lieu, tous les porteurs de charge photogénérés se recombinent en surface. La durée de vie effective des porteurs de charge $\tau_{eff}$ est donc sensiblement égale à la durée de vie surfacique des porteurs de charge $\tau_{surf}$. Par ailleurs, comme les plaquettes brutes de découpe ont une épaisseur sensiblement uniforme, le taux de génération G et la durée de vie surfacique des porteurs de charge $\tau_{surf}$ peuvent être supposés constants. L'intensité de photoluminescence $I_{PL}$ est donc proportionnelle à la concentration en porteurs de charge libres majoritaires no/po :

$$I_{PL} \propto n_0$$

dans le silicium type n ; et

$$I_{PL} \propto p_0$$

dans le silicium type p.

Ainsi, l'intensité de photoluminescence $I_{PL}$ peut être avantageusement mesurée dans les zones Z1 et Z2 de la plaquette à l'étape S1.

Les conditions d'acquisition du signal de photoluminescence lors de l'étape S1 peuvent être les suivantes :

- la source d'excitation (typiquement un laser) illumine les plaquettes en silicium à une longueur d'onde inférieure à 1100 nm, et de préférence inférieure à 915 nm, afin de générer des paires électron-trou dans la bande interdite du silicium :
- la durée d'illumination est inférieure ou égale à 30 s, et de préférence inférieure à 1 s, afin d'être compatible avec la cadence d'une ligne de production de cellules photovoltaïques ;
- la puissance de la source d'excitation est comprise entre 0,01 W/cm$^2$ et 1 W/cm$^2$ ;
- la détection de la photoluminescence est effectuée (en imagerie) à l'aide d'un photodétecteur dont la résolution spatiale est inférieure à 5 mm (dimensions des pixels : 5 mm x 5 mm), et de préférence inférieure à 1 mm (1 mm x 1 mm).

Les équipements de photoluminescence actuels permettent d'acquérir rapidement une cartographie complète de chaque plaquette. Ainsi, grâce à cette technique, il est possible d'obtenir une image (ou représentation) de la concentration en porteurs de charge libres majoritaires no/po dans un grand nombre de zones de mesure simultanément. La photoluminescence est particulièrement avantageuse dans le cadre de ce procédé de tri car elle permet, à la différence d'autres techniques de mesure de la concentration en porteurs de charge libres majoritaires, de pouvoir effectuer des mesures à très faible distance des bords de la plaquette (jusqu'à 1 mm de distance). Les équipements de photoluminescence ont par ailleurs une cadence équivalente à celle d'une ligne de production de cellules photovoltaïques. Le procédé de tri, exécuté en entrée de ligne, ne ralentira donc pas la fabrication des cellules.

Les étapes de calcul S2 et de comparaison à la valeur seuil S3 peuvent être mises en œuvre par une unité de calcul, telle qu'un microprocesseur.

Le procédé de tri décrit ci-dessus en référence à la figure 2 est applicable aussi bien aux plaquettes de silicium dopées de type n (électrons majoritaires) qu'aux plaquettes de silicium dopées de type p (trous majoritaires). Le nombre et la nature des éléments chimiques servant de dopants dans les plaquettes (bore, phosphore, arsenic, antimoine...) n'a aucune influence sur le tri. Ce procédé pourrait même être appliqué à des plaquettes dopées uniquement avec des donneurs thermiques (donc nécessairement de type n), c'est-à-dire des plaquettes issues d'un lingot dans lequel aucun dopant n'a été introduit volontairement.

Dans de rares cas, la quantité de donneurs thermiques dans une plaquette dopée de type p peut être, localement, tellement importante qu'il existe un changement du type de conductivité au sein même de la plaquette. Typiquement, les bords de la plaquette sont dopés de type p, tandis que le centre de la plaquette, riche en donneurs thermiques, deviendrait dopé de type n. Cette situation dite d'inversion du dopage peut notamment se produire lorsque la plaquette est extraite de la partie haute du lingot. Une plaquette qui présente une inversion du type de dopage (i.e. du type p au type n) ne sera pas nécessairement écartée par le procédé de tri de la figure 2, car la concentration en porteurs de charge au centre de la plaquette peut être du même ordre de grandeur que celle au bord de la plaquette. Elle aboutira pourtant à une cellule photovoltaïque très peu performante, voire à une cellule photovoltaïque inopérante.

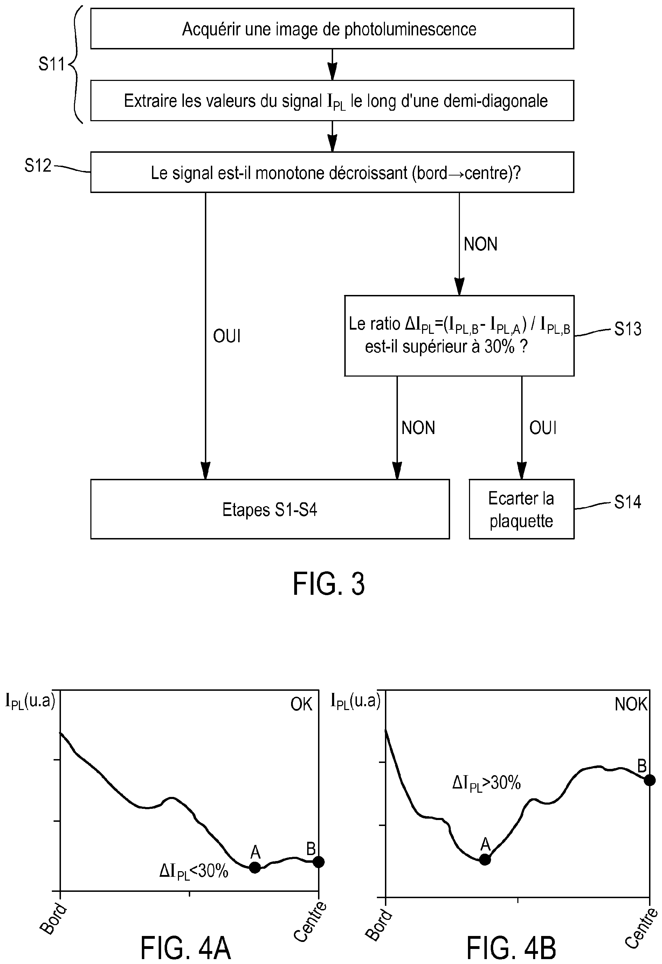

La figure 3 représente des étapes S11 à S14 d'un deuxième procédé de tri, dérivé du premier procédé décrit en relation avec la figure 2, pour identifier et écarter ce type de plaquettes.

Ce deuxième procédé de tri débute par une étape S11 pendant laquelle on effectue des mesures d'un paramètre représentatif de la concentration en porteurs de charge libres majoritaires no/po dans chaque plaquette à trier. Les points de mesure sont répartis entre un bord et le centre de la plaquette et, de préférence, alignés le long d'une demi-diagonale ou d'un rayon de la plaquette.

Dans le mode de mise en œuvre préférentiel de l'étape S11 représenté sur la figure 3, le paramètre représentatif de la concentration en porteurs de charge libres majoritaires no/po est l'intensité de photoluminescence $I_{PL}$. L'étape S11 consiste alors à acquérir une image de photoluminescence de chaque plaquette, puis à extraire de cette image des valeurs d'intensité de photoluminescence réparties entre le bord et le centre de la plaquette. À partir de ces valeurs, il est ensuite possible de tracer une courbe représentant la variation du signal I$_{PL}$ depuis le bord jusqu'au centre de la plaquette.

On vérifie ensuite, au cours d'une étape S12, si le paramètre I - ici l'intensité de photoluminescence I$_{PL}$ - diminue de façon continue depuis le bord jusqu'au centre de la plaquette, c'est-à-dire si la courbe de l'intensité I$_{PL}$ décroit de façon monotone.

Si l'intensité de photoluminescence I$_{PL}$ diminue de façon continue entre le bord et le centre de la plaquette (sortie « OUI » en S12), cela signifie qu'il n'y a pas d'inversion du type de dopage dans la plaquette. Cette diminution du signal I$_{PL}$ est représentative d'une diminution (continue) de la concentration en trous, vraisemblablement causée par une augmentation (également continue) de la concentration en donneurs thermiques. Les étapes S1 à S4 décrites précédemment en relation avec la figure 2 sont alors mises en œuvre pour vérifier si la qualité de la plaquette est satisfaisante (en réutilisant avantageusement les valeurs du signal I$_{PL}$).

Si par contre l'intensité de photoluminescence I$_{PL}$ ne diminue pas de façon continue (sortie « NON » en S12), c'est-à-dire si elle connait une augmentation entre le bord et le centre de la plaquette comme cela est représenté sur les figures 4A et 4B, des étapes supplémentaires sont mises en œuvre pour déterminer si l'augmentation de l'intensité I$_{PL}$ est simplement due à une augmentation, locale et de faible amplitude, de la concentration en dopants accepteurs N$_a$ (et/ou une diminution locale de la concentration en donneurs thermiques) ou à une inversion du type de dopage causée par une forte concentration en donneurs thermiques.

Ainsi, lors d'une étape S13, on détermine la variation radiale relative de l'intensité de photoluminescence entre le minimum de l'intensité I$_{PL}$ (dans l'exemple des figures 7A-7B, il s'agit du point « A ») et l'intensité I$_{PL}$ mesurée au centre de la plaquette (point « B »).

La variation radiale relative Δ$I_{PL}$ de l'intensité de photoluminescence entre le point A (minimum de l'intensité) et le point B (point central) s'écrit de la façon suivante :

$$\Delta I_{PL} = \frac{I_{PL,B} - I_{PL,A}}{I_{PL,B}}$$

où $I_{PL,A}$ et $I_{PL,B}$ sont les valeurs de l'intensité de photoluminescence I$_{PL}$ aux points A et B respectivement.

La variation radiale relative Δ$I_{PL}$ de l'intensité de photoluminescence est ensuite comparée à une valeur seuil, par exemple 30 %. La valeur seuil est choisie de manière à exclure des variations de l'intensité de photoluminescence qui seraient causées par des variations naturelles du dopage. Dans le silicium CZ de type p, les variations relatives de la concentration en dopants accepteurs ne dépassent généralement pas 30 %.

Si la variation radiale relative Δ$I_{PL}$ de l'intensité de photoluminescence est inférieure au seuil de 30 % (sortie « NON » en S13), la plaquette présente une augmentation locale de la concentration en dopants accepteurs N$_A$, voire une diminution locale de la concentration en donneurs thermiques [DT], mais pas une inversion du type de dopage. La plaquette n'est alors pas nécessairement de mauvaise qualité. Les étapes S1 à S4 du procédé de la figure 2 sont mises en œuvre pour estimer le risque que les performances futures de la plaquette soient limitées les donneurs thermiques (selon le critère de la variation relative radiale R). Si par contre la variation radiale relative Δ$I_{PL}$ est supérieure à 30 % (sortie « OUI » en S13), cela signifie que la plaquette présente une inversion du dopage. Cette plaquette est alors écartée lors d'une étape S14.

Les deux procédés de tri qui viennent d'être décrits en relation avec les figures 2 et 3 s'avèrent particulièrement avantageux dans le cadre de la fabrication de cellules photovoltaïques à hétérojonction, pour écarter les plaquettes qui mèneront à des rendements trop faibles, et plus particulièrement les plaquettes provenant du haut du lingot.

Bien que les cellules photovoltaïques à homojonction soient insensibles aux donneurs thermiques, les procédés de tri peuvent également être utilisés en entrée d'une ligne de production de cellules à homojonction. En effet, une concentration élevée en donneurs thermiques dans les plaquettes de silicium à l'état brut de découpe révèle souvent la présence d'autres défauts, comme des précipités d'oxygène, qui limiteront la durée de vie volumique des porteurs de charge dans les cellules finies. Ainsi, en écartant une plaquette dont la concentration en porteurs de charge libres majoritaires varie de façon significative à cause de donneurs thermiques, conformément aux procédés de tri selon l'invention, on écarte très certainement une plaquette dont la durée de vie volumique sera limitée par ces autres défauts. Enfin, contrairement au procédé de tri de l'art antérieur, les procédés de tri selon l'invention ne requièrent pas d'accomplir la première étape du procédé de fabrication des cellules à homojonction (diffusion de l'émetteur). Ils sont donc plus simples et plus économiques à mettre en œuvre.

De nombreuses variantes et modifications des procédés de tri selon l'invention apparaîtront à l'homme du métier. En particulier, les procédés de tri sont applicables à d'autres paramètres représentatifs de la concentration en porteurs de charge libres majoritaires que ceux décrits jusqu'à présent. Pour le calcul de la variation radiale relative R à l'étape S2, il est notamment possible d'utiliser des valeurs de la concentration en porteurs de charge libres majoritaires no/po, plutôt des valeurs d'un signal de mesure qui lui est proportionnel (ou inversement proportionnel). La concentration en porteurs de charge libres majoritaires no/po au bord et au centre de la plaquette peut être obtenue directement par la technique d'imagerie infrarouge appelée « Carrier Density Imaging » en anglais.

Par ailleurs, la technique de photoluminescence peut être utilisée sans toutefois acquérir une image complète de chaque plaquette. En effet, dans un mode de mise en œuvre du procédé de tri, seulement deux points de mesure peuvent suffire (au bord et au centre). Les mesures s'effectueront alors point par point, avec un spot laser millimétrique.

Les procédés de tri peuvent également être appliqués à des plaquettes qui, après avoir été livrées dans l'état brut de découpe, ont été soumises à une étape de mise en forme de la surface, telle qu'une étape de texturation ou une étape de polissage mécanique et/ou chimique.

Quel que soit leur état (brut de découpe ou avec une surface mise en forme), les plaquettes à trier sont exemptes de couche de passivation et n'ont subi aucun traitement à une température supérieure ou égale à 350°C, et de préférence aucune étape de passivation.

**Revendications**

1. Procédé de tri de plaquettes obtenues par découpage d'un lingot en silicium monocristallin de type Czochralski, le procédé étant mis en œuvre lorsque les plaquettes sont dans un état brut de découpe ou dans un état de mise en forme de leur surface et comprenant les étapes suivantes :

   a) mesurer (S1) une première valeur ($I_{Z1}$) d'un paramètre représentatif de la concentration en porteurs de charge libres majoritaires (no/po) dans une première zone (Z1) située au centre de chaque plaquette et une deuxième valeur ($I_{Z2}$) dudit paramètre dans une deuxième zone (Z2) située au voisinage immédiat d'un bord de chaque plaquette ;
   b) calculer (S2) une variation relative (R) dudit paramètre entre le bord et le centre de chaque plaquette, à partir des première et deuxième valeurs ($I_{Z1}$, $I_{Z2}$) dudit paramètre ;
   c) comparer (S3) la variation relative dudit paramètre dans chaque plaquette à une valeur seuil ($R_{lim}$) ; et
   d) écarter (S4) la plaquette lorsque la variation relative (R) dudit paramètre est supérieure à la valeur seuil ($R_{lim}$).

2. Procédé selon la revendication 1, dans lequel la première zone (Z1) de chaque plaquette est constituée d'un carré de 5 cm de côté dont le centre est confondu avec le centre de la plaquette.

3. Procédé selon l'une des revendications 1 et 2, dans lequel la deuxième zone (Z2) de chaque plaquette est constituée d'une bande de largeur égale à 5 mm et située à la périphérie de la plaquette.

4. Procédé selon l'une quelconque des revendications 1 à 3, dans lequel ledit paramètre est un signal proportionnel ou inversement proportionnel à la concentration en porteurs de charge libres majoritaires ($n_0/p_0$).

5. Procédé selon la revendication 4, dans lequel ledit paramètre est une intensité de photoluminescence ($I_{PL}$).

6. Procédé selon la revendication 5, dans lequel l'épaisseur des plaquettes est inférieure à 580 $\mu$m.

7. Procédé selon l'une quelconque des revendications 1 à 6, dans lequel la première valeur ($I_{Z1}$) dudit paramètre est une valeur moyenne de plusieurs valeurs dudit paramètre mesurées dans la première zone (Z1).

8. Procédé selon l'une quelconque des revendications 1 à 6, dans lequel les étapes a) et b) sont en outre mises en œuvre pour des zones additionnelles (Z3) de chaque plaquette, d'où il résulte une pluralité de valeurs de variation relative (R) dudit paramètre pour chaque plaquette, le procédé comprenant en outre une étape de détermination, parmi la pluralité de valeurs de variation relative, d'une valeur maximale de variation relative, ladite valeur maximale étant comparée à la valeur seuil ($R_{lim}$) à l'étape c).

9. Procédé selon l'une quelconque des revendications 1 à 8, dans lequel les plaquettes sont dopées de type n.

10. Procédé de tri de plaquettes obtenues par découpage d'un lingot en silicium monocristallin de type Czochralski contenant des dopants de type p, le procédé étant mis en œuvre lorsque les plaquettes sont dans un état brut de découpe ou dans un état de mise en forme de leur surface et comprenant les étapes suivantes :

    - effectuer des mesures d'un paramètre représentatif de la concentration en porteurs de charge libres majoritaires

($n_0/p_0$) sur chaque plaquette, les mesures étant réparties entre un bord et le centre de la plaquette ;
- déterminer si ledit paramètre diminue de façon continue entre le bord et le centre de chaque plaquette ; et

lorsque ledit paramètre diminue de façon continue, les étapes suivantes :

a) extraire (S1) des mesures une première valeur ($I_{Z1}$) dudit paramètre dans une première zone (Z1) située au centre de la plaquette et une deuxième valeur ($I_{Z2}$) dudit paramètre dans une deuxième zone (Z2) située au voisinage immédiat d'un bord de la plaquette ;
b) calculer (S2) une première variation relative (R) dudit paramètre entre le bord et le centre de la plaquette, à partir des première et deuxième valeurs ($I_{Z1}$-$I_{Z2}$) dudit paramètre ;
c) comparer (S3) la première variation relative dudit paramètre à une première valeur seuil ($R_{lim}$) ; et
d) écarter (S4) la plaquette lorsque la première variation relative (R) dudit paramètre est supérieure à la première valeur seuil ($R_{lim}$) ; et

lorsque ledit paramètre ne diminue pas de façon continue, les étapes suivantes :

- déterminer une deuxième variation relative ($\Delta I_{PL}$) dudit paramètre entre le minimum (A) dudit paramètre et une valeur dudit paramètre au centre (B) de la plaquette ;
- comparer la deuxième variation relative dudit paramètre à une deuxième valeur seuil ;
- écarter la plaquette lorsque la deuxième variation relative ($\Delta I_{PL}$) dudit paramètre est supérieure à la deuxième valeur seuil ;
- mettre en œuvre les étapes a) à d) lorsque la deuxième variation relative ($\Delta I_{PL}$) dudit paramètre est inférieure à la deuxième valeur seuil.

## Patentansprüche

1. Verfahren zum Sortieren von Wafern, die per Ausschneiden aus einem monokristallinen Siliziumblock vom Typ Czochralski erhalten werden, wobei das Verfahren umgesetzt wird, wenn die Wafer in einem Rohzustand des Ausschnitts oder in einem geformten Zustand ihrer Oberfläche sind und die folgenden zwei Schritte umfasst:

   a) Messen (S1) eines ersten Wertes ($I_{z1}$) eines Parameters, der die Konzentration von Trägern von mehrheitlichen freien Chargen ($n_0/p_0$) in einem ersten Bereich (Z1) darstellt, der im Zentrum jedes Wafers angeordnet ist, und eines zweiten Wertes ($I_{z2}$) de genannten Parameters in einem zweiten Bereich (Z2), der in der unmittelbaren Nachbarschaft eines Randes jedes Wafers angeordnet ist;
   b) Berechnen (S2) einer relativen Abweichung (R) des genannten Parameters zwischen dem Rand und dem Zentrum jedes Wafers von dem ersten und dem zweiten Wert ($I_{z1}$, $I_{z2}$) des genannten Parameters;
   c) Vergleichen (S3) der relativen Abweichung des genannten Parameters in jedem Wafer mit einem Schwellenwert ($R_{lim}$); und
   d) Aussortieren (S4) des Wafers, wenn der relative Wert (R) des genannten Parameters größer ist als der Schwellenwert ($R_{lim}$).

2. Verfahren gemäß Anspruch 1, bei dem der erste Bereich (Z1) jedes Wafers aus einem Quadrat mit 5 cm großen Seiten gebildet wird, dessen Zentrum mit dem Zentrum des Wafers zusammenfällt.

3. Verfahren gemäß einem der Ansprüche 1 und 2, bei dem der zweite Bereich (Z2) jedes Wafers aus einem Band mit einer Breite gleich 5 mm gebildet wird und an der Peripherie des Wafers angeordnet wird.

4. Verfahren gemäß irgendeinem der Ansprüche 1 bis 3, bei dem der genannte Parameter ein Signal ist, der proportional zu oder umgekehrt proportional zur Konzentration an Trägern von mehrheitlichen freien Chargen ($n_0/p_0$) ist.

5. Verfahren gemäß Anspruch 4, bei dem der genannte Parameter eine Fotolumineszenz-Intensität ist ($I_{PL}$).

6. Verfahren gemäß Anspruch 5, bei dem die Dicke der Wafer geringer ist als 580 $\mu$m.

7. Verfahren gemäß irgendeinem der Ansprüche 1 bis 6, bei dem der erste Wert ($I_{z1}$) des genannten Parameters ein durchschnittlicher Wert aus mehreren Werten des genannten Parameters ist, der in dem ersten Bereich (Z1) gemessen wird.

**8.** Verfahren gemäß irgendeinem der Ansprüche 1 bis 6, bei dem die Schritte a) und b) weiterhin für zusätzliche Bereiche (Z3) jedes Wafers umgesetzt werden, was zu einer Vielzahl von Werten mit relativer Abweichung (R) des genannten Parameters für jeden Wafer führt, wobei das Verfahren weiterhin einen Bestimmungsschritt eines maximalen Wertes mit relativer Abweichung aus der Vielzahl von Werten mit relativer Abweichung umfasst, wobei der genannte maximale Wert mit dem Schwellenwert ($R_{lim}$) in Schritt c) verglichen wird.

**9.** Verfahren gemäß irgendeinem der Ansprüche 1 bis 8, bei dem die Wafer vom Typ n dotiert sind.

**10.** Verfahren zum Sortieren von Wafern, die per Ausschneiden aus einem monokristallinen Siliziumblock vom Typ Czochralski erhalten werden, der Dotanten vom Typ p enthält, wobei das Verfahren umgesetzt wird, wenn die Wafer in einem Rohzustand des Ausschnitts oder in einem geformten Zustand ihrer Oberfläche sind und die folgenden zwei Schritte umfasst:

- Durchführen der Messungen eines Parameters, der die Konzentration an Trägern von mehrheitlichen freien Chargen ($n_0/p_0$) darstellt, auf jedem Wafer, wobei die Messungen zwischen einem Rand und dem Zentrum des Wafers verteilt sind;
- Bestimmen, ob der genannte Parameter zwischen dem Rand und dem Zentrum jedes Wafers kontinuierlich abnimmt; und

wenn der genannte Parameter kontinuierlich abnimmt, die folgenden Schritte:

a) Extrahieren (S1) der Messungen eines ersten Wertes ($I_{z1}$) des genannten Parameters in einem ersten Bereich (Z1), der im Zentrum des Wafers angeordnet ist, und eines zweiten Wertes ($I_{z2}$) des genannten Parameters in einem zweiten Bereich (Z2), der in der unmittelbaren Nachbarschaft eines Randes jedes Wafers angeordnet ist;
b) Berechnen (S2) einer ersten relativen Abweichung (R) des genannten Parameters zwischen dem Rand und dem Zentrum des Wafers von dem ersten und dem zweiten Wert ($I_{z1}$-$I_{z2}$) des genannten Parameters;
c) Vergleichen (S3) der ersten relativen Abweichung des genannten Parameters mit einem ersten Schwellenwert ($R_{lim}$); und
d) Aussortieren (S4) des Wafers, wenn die erste relative Abweichung (R) des genannten Parameters größer ist als der erste Schwellenwert ($R_{lim}$); und

wenn der genannte Parameter nicht kontinuierlich abnimmt, die folgenden Schritte:

- Bestimmen einer zweiten relativen Abweichung ($\Delta I_{PL}$) des genannten Parameters zwischen dem Minimum (A) des genannten Parameters und ein Wert des genannten Parameters im Zentrum (B) des Wafers;
- Vergleichen der zweiten relativen Abweichung des genannten Parameters mit einem zweiten Schwellenwert; und
- Aussortieren des Wafers, wenn die zweite relative Abweichung ($\Delta I_{PL}$) des genannten Parameters größer ist als der zweite Schwellenwert;
- Umsetzen der Schritte a) bis d), wenn die zweite relative Abweichung ($\Delta I_{PL}$) des genannten Parameters kleiner ist als der zweite Schwellenwert;

**Claims**

**1.** Method for sorting wafers obtained by cutting of a Czochralski-type monocrystalline silicon ingot, the method being carried out when the wafers are in an as-cut state or in a surface-shaped state and comprising the following steps:

a) measuring (S1) a first value ($I_{z1}$) of a parameter representative of the majority free charge carrier concentration ($n_0/p_0$) in a first zone (Z1) situated at the centre of each wafer and a second value ($I_{z2}$) of said parameter in a second zone (Z2) situated in the immediate vicinity of an edge of each wafer;
b) calculating (S2) a relative variation (R) of said parameter between the edge and the centre of each wafer, from the first and second values ($I_{z1}$, $I_{z2}$) of said parameter;
c) comparing (S3) the relative variation of said parameter in each wafer with a threshold value ($R_{lim}$); and
d) discarding (S4) the wafer when the relative variation (R) of said parameter is above the threshold value ($R_{lim}$).

**2.** Method according to claim 1, wherein the first zone (Z1) of each wafer is constituted of a square of 5 cm sides of which the centre is merged with the centre of the wafer.

**3.** Method according to one of claims 1 and 2, wherein the second zone (Z2) of each wafer is constituted of a strip of width equal to 5 mm and situated at the periphery of the wafer.

**4.** Method according to any of claims 1 to 3, wherein said parameter is a signal proportional or inversely proportional to the majority free charge carrier concentration ($n_0/p_0$).

**5.** Method according to claim 4, wherein said parameter is a photoluminescence intensity ($I_{PL}$).

**6.** Method according to claim 5, wherein the thickness of the wafers is less than 580 $\mu$m.

**7.** Method according to any of claims 1 to 6, wherein the first value ($I_{Z1}$) of said parameter is an average value of several values of said parameter measured in the first zone (Z1).

**8.** Method according to any of claims 1 to 6, wherein steps a) and b) are further carried out for additional zones (Z3) of each wafer, resulting in a plurality of values of relative variation (R) of said parameter for each wafer, the method further comprising a step of determining, among the plurality of relative variation values, a maximum relative variation value, said maximum value being compared with the threshold value ($R_{lim}$) at step c).

**9.** Method according to any of claims 1 to 8, wherein the wafers are n-type doped.

**10.** Method for sorting wafers obtained by cutting of a Czochralski-type monocrystalline silicon ingot containing p type dopants, the method being carried out when the wafers are in an as-cut state or in a surface-shaped state and comprising the following steps:

- making measurements of a parameter representative of the majority free charge carrier concentration (no/po) on each wafer, the measurements being distributed between an edge and the centre of the wafer;
- determining if said parameter decreases continuously between the edge and the centre of each wafer; and

when said parameter decreases continuously, the following steps:

a) extracting (S1) from the measurements a first value ($I_{Z1}$) of said parameter in a first zone (Z1) situated at the centre of the wafer and a second value ($I_{Z2}$) of said parameter in a second zone (Z2) situated in the immediate vicinity of an edge of the wafer;
b) calculating (S2) a first relative variation (R) of said parameter between the edge and the centre of the wafer, from the first and second values ($I_{Z1}-I_{Z2}$) of said parameter;
c) comparing (S3) the first relative variation of said parameter with a first threshold value ($R_{lim}$); and
d) discarding (S4) the wafer when the first relative variation (R) of said parameter is above the first threshold value ($R_{lim}$); and

when said parameter does not decrease continuously, the following steps:

- determining a second relative variation ($\Delta I_{PL}$) of said parameter between the minimum (A) of said parameter and a value of said parameter at the centre (B) of the wafer;
- comparing the second relative variation of said parameter with a second threshold value;
- discarding the wafer when the second relative variation ($\Delta I_{PL}$) of said parameter is above the second threshold value;
- carrying out steps a) to d) when the second relative variation ($\Delta I_{PL}$) of said parameter is below the second threshold value.

FIG. 1

**FIG. 2**

S11 {

Acquérir une image de photoluminescence

Extraire les valeurs du signal $I_{PL}$ le long d'une demi-diagonale

S12 — Le signal est-il monotone décroissant (bord→centre)?

NON

OUI

Le ratio $\Delta I_{PL}=(I_{PL,B}-I_{PL,A})\,/\,I_{PL,B}$ est-il supérieur à 30% ? — S13

NON

OUI

Etapes S1-S4

Ecarter la plaquette — S14

## FIG. 3

$I_{PL}(u.a)$

OK

$\Delta I_{PL}<30\%$

A

B

Bord

Centre

## FIG. 4A

$I_{PL}(u.a)$

NOK

B

$\Delta I_{PL}>30\%$

A

Bord

Centre

## FIG. 4B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070193501 A

**Littérature non-brevet citée dans la description**

- **J. HAUNSCHILD et al.** Quality Control of Czochralski Grown Silicon Wafers in Solar Cell Production Using Photoluminescence Imaging. *26th European PV Solar Energy Conférence and Exhibition,* 05 Septembre 2011

- **J. BROISCH et al.** A New Method for the Détermination of the Dopant-Related Base Resistivity Despite the Presence of Thermal Donors. *IEEE Journal of Photovoltaics,* 2015, vol. 5 (1